# EUROPÄISCHE PATENTSCHRIFT

(11) **EP 0 303 314 B1**
(45) Veröffentlichungstag und Bekanntmachung des Hinweises auf die Patenterteilung: **08.12.1993**
(21) Anmeldenummer: 88201615.7
(22) Anmeldetag: 26.07.1988
(51) Int. Cl.: H03K 17/16, H05B 1/02, H03K 17/725

(54) **Verfahren zur schaltstossarmen Leistungssteuerung elektrischer Lasten**
Method for power control of electric loads without commutation pulse
Procédé de contrôle de puissance de charges électriques sans impulsion de commutation

(30) Priorität: 10.08.1987 DE 3726535
(43) Veröffentlichungstag der Anmeldung: 15.02.1989
(73) Patentinhaber: Philips Patentverwaltung GmbH, 22335 Hamburg (DE); Philips Electronics N.V., 5621 BA Eindhoven (NL)
(72) Erfinder: Kersten, Reinhard, Dr., D-5100 Aachen (DE); Kühlmorgen, Joachim, D-5100 Aachen (DE); Kuhl, Egbert, D-5100 Aachen (DE)
(74) Vertreter: Kupfermann, Fritz-Joachim, Dipl.-Ing.

(56) Entgegenhaltungen:
- EP-A- 0 162 620
- WO-A-86/00689
- DE-B- 1 801 404
- GB-A- 2 041 674

## Beschreibung

Die Erfindung bezieht sich auf ein Verfahren zur schaltstoßarmen Leistungssteuerung elektrischer Lasten, insbesondere Heizlasten, welche in je wenigstens zwei gleiche Unterlasten elektrisch aufgeteilt sind, bei dem die Unterlasten jeder Last wahlweise in wenigstens drei Haupt-Leistungsstufen in Serienschaltung, wechselweise einzeln oder in Parallelschaltung an ein Wechselstromnetz schaltbar sind.

Bei der Leistungssteuerung elektrischer Lasten hoher Leistungsaufnahme beispielsweise der Herdplatten eines Elektroherdes, besteht vielfach der Wunsch, möglichst viele, fein abgestufte Leistungsstufen zur Verfügung zu haben. Zu diesem Zweck ist es beispielsweise für Herdplatten bekannt, eine sogenannte Dreipunktregelung vorzusehen, bei denen mehrere Wicklungen parallel vorgesehen sind, welche verschiedene Leistungsaufnahmen zulassen. Eine derartige Anordnung ist jedoch sehr aufwendig und insbesondere für viele Leistungsstufen wirtschaftlich nicht vertretbar.

Aus der EP-A2 0 162 620 ist das eingangs erwähnte Verfahren bekannt, jede Last in mehrere Unterlasten aufzuteilen, d.h. also beispielsweise eine Heizwicklung in mehrere Teilwicklungen in der Weise zu unterteilen, daß die Teilwicklungen in Serienschaltung oder in Parallelschaltung an die Spannungsversorgung geschaltet werden können. Ist dabei jede Heizlast in zwei Unterlasten unterteilt, ergibt sich für jede Heizlast eine Haupt-Leistungsstufe. Sind die Unterlasten in Parallelschaltung an das Netz geschaltet, so haben sie die höchste Stromaufnahme. Die Leistungsstufe mit der geringsten Leistungsaufnahme ist die Serienschaltung, in der beide Wicklungen in Serie an das Netz geschaltet sind. Bei einem derartigen Verfahren zur Leistungssteuerung sind somit bei in zwei Unterlasten aufgeteilten Heizlasten mehrere Haupt-Leistungsstufen möglich. Eine derartige Leistungsabstufung ist jedoch für einige Einsatzzwecke, beispielsweise für Herdplatten eines Elektroherdes, häufig nicht ausreichend.

Für eine Leistungssteuerung mit feinerer Abstufung der Leistungsaufnahmen bestünde die Möglichkeit, zwischen den Haupt-Leistungsstufen hin- und herzuschalten bzw. die Haupt-Leistungsstufen jeweils nur für bestimmte Zeiten einzuschalten. Dabei ergibt sich jedoch infolge der hohen Leistungsaufnahme das Problem der Netzrückwirkung. Beim Ein- und Ausschalten der Lasten entstehen nämlich Schaltstöße, die entsprechende Netzspannungsschwankungen auslösen. Auf derartige Netzspannungsschwankungen reagiert das Auge insbesondere in einem Frequenzbereich unterhalb von 25 Hz sehr empfindlich. Es gibt daher für entsprechende Geräte Vorschriften zur Einhaltung genügend kleiner Schaltstöße und dadurch ausgelöster Netzrückwirkungen. Eine einschlägige Vorschrift dazu ist der IEC Standard 555 "Disturbances in supply systems caused by houshold appliances and similar electrical equipment". In diesem Standard ist festgelegt, welchen Oberwellengehalt oberhalb von 50 Hz und welche Netzspannungsschwankungen unterhalb von 50 Hz durch an ein Netz geschaltete elektrische Lasten ausgelöst werden dürfen. Außerdem ist hierbei eine sehr geringe Netto-Gleichstrombelastung vorgeschrieben.

Konkret ergibt sich für die Einhaltung derartiger Standards das Problem, daß insbesondere für Lasten oberhalb von 500 W kleinere Schaltzeiten zwischen den oben genannten Haupt-Leistungsstufen praktisch nicht mehr möglich sind, da dann die Norm nicht mehr eingehalten wird. Es sei noch erwähnt, daß die durch Geräte mit hoher Leistungsaufnahme ausgelösten Netzspannungsschwankungen häufig als Flickern bezeichnet werden.

Mit den in der oben erwähnten EP-A2 0 162 620 vorgesehenen Leistungsstufen läßt sich der IEC-Standard nicht einhalten, da die Schaltstoßbelastungen bei Umschaltung zwischen verschiedenen Stufen zu groß ist und außerdem eine unzulässige Netto-Gleichstrombelastung auftritt.

Aus der DE-OS 34 26 046 ist noch ein elektrischer Durchlauferhitzer bekannt, bei dem zwei Leistungsstufen vorgesehen sind. Die niedrigere Leistungsstufe wird mittels einer Last realisiert, die aus zwei parallelgeschalteten Heizwiderständen besteht, welche an eine Phase eines Drehstromnetzes angeschlossen sind. Die höhere Leistungsstufe wird durch in einer Sternschaltung geschaltete Heizwiderstände verwirklicht, die an die Phasen eines Drehstromnetzes angelegt sind. Hierbei werden also zwei Hauptleistungsstufen durch mehr als zwei Unterlasten realisiert. Die höhere Leistungsstufe ist nicht durch ein Wechselstromnetz realisierbar, sondern nur durch ein Drehstromnetz.

Es ist Aufgabe der Erfindung, ein Verfahren zur schaltstoßarmen Leistungssteuerung elektrischer Lasten, insbesondere Lasten hoher Leistungsaufnahme, zu schaffen, daß zusätzlich zu den bekannten Haupt-Leistungsstufen weitere Fein-Leistungsstufen bietet, welche die einschlägigen internationalen Normen für Schaltstoßbelastungen und Netto-Gleichstrombelastungen von Wechselstromnetzen einhalten.

Diese Aufgabe ist erfindungsgemäß dadurch gelöst, daß zur feineren Leistungssteuerung zusätzlich sechs Zwischen-Leistungsstufen vorgesehen sind, bei denen ausgehend von einer der drei Haupt-Leistungsstufen in einem sich laufend wiederholenden Zyklus von sechs Wechselstrom-Halbwellen in den ersten Zwischen-Leistungsstufen während der dritten und sechsten Halbwelle in jedem Zyklus und in den zweiten Zwischenleistungsstufen zusätzlich während der zweiten und fünften Halbwelle auf die jeweils nächstniedrigere Haupt-Leistungsstufe geschaltet wird, die im Fall der Serienschaltung die abgeschaltete Leistungsaufnahme ist.

Nach diesem Verfahren sind zusätzlich zu den Haupt-Leistungsstufen weitere Zwischen-Leistungsstufen vorgesehen. Dazu ist ein Zyklus vorgesehen, der sechs Wechselstrom-Halbwellen aufweist. Ein derartiger Zyklus wiederholt sich laufend. Bei einer Zykluslänge von sechs Halbwellen wird keine Netto-Gleichstrombelastung über die Länge eines Zyklus zugelassen.

Für Lasten, welche je zwei Unterlasten aufweisen, die in drei Haupt-Leistungsstufen an ein Wechselstromnetz schaltbar sind, wird also ein Zyklus von sechs Wechselstrom-Halbwellen vorgesehen. Dabei wird zur Einhaltung der einschlägigen Normen zur maximalen Schaltstoßbelastung in ersten Zwischen-Leistungsstufen während jeder dritten und sechsten Halbwelle in jedem Zyklus eine Haupt-Leistungsstufe niedriger geschaltet. Zusätzlich sind zweite Zwischen-Leistungsstufen vorgesehen, in denen zusätzlich zu den dritten und sechsten Halbwellen auch während der jeweils zweiten und fünften Halbwelle auf die jeweils nächstniedrige Haupt-Leistungsstufe geschaltet wird. Es gibt also ausgehend von jeder der drei Haupt-Leistungsstufen je zwei Zwischenleistungsstufen, so daß insgesamt sechs Zwischen-Leistungsstufen vorhanden sind.

Es wird also ausgehend von einer der drei Hauptleistungsstufen in jedem derartigen Zyklus während mehrerer festliegender Wechselstrom-Halbwellen in jedem Zyklus eine Hauptleistungsstufe niedriger geschaltet. Ist beispielsweise ausgehend von der Parallelschaltung zweier Unterlasten eine weitere Zwischen-Leistungsstufe vorgesehen, so wird für diese ausgehend von der Hauptleistungsstufe der Parallelschaltung beispielsweise in jeder dritten und sechsten Wechselstrom-Halbwelle eines jeden Zyklus eine Haupt-Leistungsstufe niedriger geschaltet. Dies bedeutet in dem vorliegenden Beispiel, daß während jeder dritten und sechsten Wechselstrom-Halbwelle in jedem Zyklus von Parallelschaltung umgeschaltet wird auf die wechselweise einzelne Einschaltung der Unterlasten. Es wird also während aller Wechselstrom-Halbwellen in jedem Zyklus die Parallelschaltung eingeschaltet, jedoch während jeder dritten Wechselstrom-Halbwelle entweder die erste Unterlast oder die zweite Unterlast oder während jeder sechsten Wechselstrom-Halbwelle entweder die zweite Unterlast oder die erste Unterlast der Heizlast. Ausgehend von diesem Beispiel können weitere Zwischen-Leistungsstufen geschaffen werden. In diesem Beispiel würde dann für die zweite Zwischen-Leistungsstufe, die von der Haupt-Leistungsstufe der Parallelschaltung der beiden Lasten ausgeht, zusätzlich auch in jeder zweiten und fünften Halbwelle auf die nächstniedrige Haupt-Leistungsstufe geschaltet. Dies bedeutet im vorliegenden Beispiel, daß auch während dieser Halbwellen wechselweise die beiden Unterlasten einzeln eingeschaltet werden. Ein Zyklus dieser zweiten Zwischen-Leistungsstufe sieht dann beispielsweise derart aus, daß während der zweiten und fünften Halbwelle auf die erste Unterlast, während der dritten und sechsten Halbwelle auf die zweite Unterlast geschaltet wird und daß während der ersten und vierten Halbwelle jedes Zyklus die beiden Lasten parallel an das Netz geschaltet sind. Da ein Zyklus aus sechs Wechselstrom-Halbwellen besteht, sind zwischen zwei Haupt-Leistungsstufen auf die oben beschriebene Weise maximal zwei Zwischen-Leistungsstufen vorgesehen, die bei gleichen Unterlasten keine Netto-Gleichstrombelastung des Netzes verursachen.

Selbstverständlich kann auch zwischen den übrigen Haupt-Leistungsstufen in der oben beschriebenen Weise weitere Zwischen-Leistungsstufen geschaffen werden. So wird beispielsweise ausgehend von der Haupt-Leistungsstufe, in der die Unterlasten einer Last wechselweise eingeschaltet sind, während einiger Wechselstrom-Halbwellen in dem Zyklus auf die Haupt-Leistungsstufe-Serienschaltung zurückgeschaltet.

Für die Serienschaltung der beiden Unterlasten ergeben sich die beiden von dieser Haupt-Leistungsstufe ausgehenden Zwischen-Leistungsstufen dadurch, daß in der ersten Zwischen-Leistungsstufe während der dritten und der sechsten Halbwelle auf die Leistungsaufnahme Null geschaltet wird und daß in der zweiten Zwischen-Leistungsstufe zusätzlich während jeder zweiten und fünften Halbwelle in jedem Zyklus auf die Leistungsaufnahme Null geschaltet wird. In dem vorliegenden Beispiel ergeben sich also zusätzlich zu den drei Haupt-Leistungsstufen insgesamt sechs Zwischen-Leistungsstufen.

Durch Einsatz des Verfahrens ergeben sich so insgesamt neun Leistungsstufen, wobei auch für die Zwischen-Leistungsstufen eine geringe Schaltstoßbelastung gegeben ist. Insbesondere ist Vorteil des Verfahrens, daß der Frequenzbereich, in dem eine Rest-Schaltstoßbelastung auftritt, frei wählbar ist und so auf die jeweils gültigen Normen eingestellt werden kann. Die Umschaltung einzelner Halbwellen ermöglicht eine Schaltstoßbelastung in einem unkritischen Frequenzbereich. Das Verfahren bietet darüber hinaus den Vorteil, daß es mittels einfach aufgebauter Vorrichtungen durchführbar ist. Insbesondere sind dabei für den mechanischen Aufbau der Heizlasten keine besonderen Vorrichtungen notwendig, es muß lediglich pro Last wenigstens zwei Unterlasten vorgesehen sein. Es ergibt sich also für die Vorrichtung ein wirtschaftlicher Aufbau.

Es sei noch erwähnt, daß aus der DE-AS 18 01 404 oder der DE-OS 30 03 451 jeweils eine Schaltungsanordnung zur Leistungssteuerung bekannt ist, bei der in der höchsten Leistungsstufe alle Wechselstrom-Halbwellen eines Zyklus an eine Last geschaltet werden. Bei niedrigeren Leistungsstufen werden Wechselstrom-Halbwellen abgeschaltet. Mit dieser Schaltungsanordnung läßt sich also keine Last steuern, die wenigstens zwei Unterlasten enthält. Somit ist z.B. eine Realisierung einer Zwischen-Leistungsstufe, die von einer Hauptleistungsstufe der Parallelschaltung ausgeht, nicht möglich.

Nach einer weiteren Ausgestaltung der Erfindung ist vorgesehen, daß zum Umschalten von einer ersten auf eine zweite, höhere Leistungsstufe ausgehend von der ersten Leistungsstufe nacheinander und in aufsteigender Folge die jeweils nächsthöhere Leistungsstufe für die Dauer wenigstens eines Zyklus eingeschaltet wird bis die zweite Leistungsstufe erreicht ist.

Das Verfahren gestattet es auch, mit geringen Schaltstoßbelastungen des Netzes zwischen verschiedenen Leistungsstufen umzuschalten, welche sowohl Haupt-Leistungsstufen, wie auch Zwischen-Leistungsstufen sein können. Dazu wird ausgehend von der ersten Leistungsstufe in der Weise auf eine zweite, höhere Leistungsstufe umgeschaltet, daß zunächst die über der ersten Leistungsstufe liegende, nächsthöhere Leistungsstufe eingeschaltet wird. Dies geschieht für die Dauer wenigstens eines Zyklus. Anschließend wird ausgehend von dieser Leistungsstufe wiederum die nächsthöhere eingeschaltet, und zwar ebenfalls für die Dauer wenigstens eines Zyklus. In dieser Weise wird weiterverfahren, bis die zweite, einzuschaltende Leistungsstufe erreicht ist. Auch bei den auf diese Weise für die Dauer wenigstens eines Zyklus eingeschalteten, zwischen der ersten und zweiten Leistungsstufe liegenden Leistungsstufen, kann es sich sowohl um Haupt-Leistungsstufen, wie auch um Zwischen-Leistungsstufen handeln. Wird beim Umschalten auf diese Weise verfahren, ergeben sich nur geringfügig höhere Schaltstoßbelastungen des Netzes als bei Dauereinschaltung einer der Leistungsstufen.

Nach einer weiteren Ausgestaltung der Erfindung ist vorgesehen, daß zum Umschalten auf eine zweite, niedrigere Leistungsstufe in entsprechender Weise mit absteigender Folge der Leistungsstufen verfahren wird. Weist die zweite, einzuschaltende Leistungsstufe eine niedrigere Leistungsaufnahme als die erste Leistungsstufe auf, so wird vorteilhafter Weise in ähnlicher Weise verfahren, jedoch in absteigender Folge der Leistungsstufen. Auch hier gilt wieder, daß alle zwischen der ersten und der zweiten Leistungsstufe liegende Leistungsstufen für die Dauer wenigstens eines Zyklus eingeschaltet werden.

Nach einer weiteren Ausgestaltung der Erfindung ist vorgesehen, daß beim Einschalten der Unterlasten auf eine beliebige Leistungsstufe zunächst für die Dauer wenigstens eines Zyklus auf die niedrigste Zwischen-Leistungsstufe geschaltet wird.

Um auch beim Einschalten auf eine beliebige Leistungsstufe eine möglichst geringe Schaltstoßbelastung zu erzielen, wird nach dem Einschaltvorgang der Leistungsstufe zunächst auf die niedrigste, zur Verfügung stehende Zwischen-Leistungsstufe geschaltet. Dies geschieht für die Dauer wenigstens eines Zyklus. Anschließend wird dann die vorgewählte Leistungsstufe eingeschaltet, welche wiederum sowohl eine Haupt- wie auch eine Zwischen-Leistungsstufe sein kann. Durch die Einschaltung der niedrigsten Zwischen-Leistungsstufe vor der angewählten Leistungsstufe ergibt sich beim Einschalten insbesondere höherer Leistungen eine deutlich verringerte Einschaltstoßbelastung des Netzes.

Nach einer weiteren Ausgestaltung der Erfindung ist vorgesehen, daß weitere Zwischenabstufungen der Leistungsaufnahme vorgesehen sind, für die zwischen zwei benachbarten Leistungsstufen für die Dauer von ganzen Vielfachen eines Zyklus hin- und hergeschaltet wird.

Das Verfahren bietet zur noch weiter verfeinerten Leistungsabstufung die Möglichkeit, zwischen zwei benachbarten Leistungsstufen für die Dauer von ganzen Vielfachen eines Zyklus hin- und herzuschalten. Es ergeben sich somit noch weitere Leistungsstufen, für die die Schaltstoßbelastung des Netzes kaum höher ist.

Nach einer weiteren Ausgestaltung der Erfindung ist vorgesehen, daß weitere Leistungsstufen unterhalb der kleinsten Zwischen-Leistungsstufe vorgesehen sind, für die zwischen dieser und der abgeschalteten Leistungsaufnahme für die Dauer ganzer Vielfacher eines Zyklus hin- und hergeschaltet wird.

In einigen Anwendungsfällen kann der Wunsch bestehen, unterhalb der kleinsten erfindungsgemäßen Zwischen-Leistungsstufe noch weitere Leistungsstufen vorzusehen. Es besteht daher die Möglichkeit, zwischen der kleinsten Zwischen-Leistungsstufe und der abgeschalteten Leistungsaufnahme für die Dauer ganzer Vielfacher eines Zyklus hin und her zu schalten. Es ist dabei auch möglich, die Zahl der Zyklen für die die kleinste Zwischen-Leistungsstufe die Leistungsaufnahme Null eingeschaltet sind, verschieden groß zu halten. Es kann beispielsweise für die Dauer eines Zyklus die kleinste Zwischen-Leistungsstufe eingeschaltet sein und für die Dauer zweier Zyklen die Leistungsaufnahme abgeschaltet sein. Die Zahl der Zyklen ist jeweils weiter variierbar, so daß sich theoretisch beliebig viele weitere Leistungsstufen unterhalb der kleinsten Zwischen-Leistungsstufe vorsehen lassen.

Insbesondere für Lasten, die als Unterlasten Halogenlampen verwenden, wie sie zunehmend in Elektroherden vorgesehen sind, ergeben sich Probleme bei der Schaltstoßbelastung, da die Wolframwendeln derartiger Halogenlampen im Kaltzustand einen niedrigeren Widerstand aufweisen, als im Heißzustand. Dies bedeutet, daß sich für derartige Lasten besonders hohe Schaltstoßbelastungen beim Einschalten der Lasten ergeben. Insbesondere für diese Lasten bietet das erfindungsgemäße Verfahren große Vorteile, da es auch für derartige Halogenlampen mit beispielsweise je 800 W Leistungsaufnahme gestattet, eine Leistungssteuerung mit feiner Abstufung vorzunehmen.

Darüber hinaus ergibt das hier beschriebene Verfahren einen nur wenig flimmernden Lichteindruck, weil die Schaltungsänderungen innerhalb der hier beschriebenen Zyklen noch ausreichend schnell ablaufen.

Nach einer weiteren Ausgestaltung der Erfindung ist vorgesehen, daß bei Betrieb zweier oder mehr Lasten, deren Unterlasten auf Zwischen-Leistungsstufen geschaltet sind, der Zyklus der zweiten Last gegenüber dem Zyklus der ersten Last zeitlich um die Dauer von zwei Halbwellen verschoben wird, wenn die erste Last auf eine der ersten Zwischen-Leistungsstufen geschaltet ist, und daß ihr Zyklus um die Dauer einer Halbwelle verschoben wird, wenn sie auf eine der zweiten Zwischen-Leistungsstufen geschaltet ist.

Bei einer derartigen Verschiebung der zweiten Last gegenüber der ersten Last ergibt sich vor allem der Vorteil, daß diejenigen Halbwellen in den jeweiligen Zyklen der beiden Lasten, während derer die Lasten eine relativ hohe Leistungsaufnahme haben, nicht zeitlich zusammenfallen, sondern gegeneinander um wenigstens eine Halbwelle verschoben sind. Damit ergibt sich bei Betrieb zweier oder mehrer Lasten eine relativ gleichmäßige Leistungsentnahme aus dem Netz.

Die Erfindung betrifft ferner ein Licht-Kochgerät mit wenigstens einer Heizlast, die zwei als Unterlasten vorgesehene Halogenlampen enthält, welche mit Schaltern eine Brückenschaltung bilden, und mit einer Steuereinheit, welche die Schalter so steuert, daß die Unterlasten über mindestens sechs Wechselstrom-Halbwellen wahlweise in drei Haupt-Leistungsstufen in Serienschaltung, welchselweise einzeln oder in Parallelschaltung an ein Wechselstromnetz schaltbar sind. Hierbei ist vorgesehen, daß die Steuereinheit die Schalter so steuert, daß zusätzlich die Unterlasten wahlweise in sechs Zwischenleistungsstufen schaltbar sind, wobei ausgehend von einer der drei Haupt-Leistungsstufen in einem sich laufend wiederholenden Zyklus von sechs Wechselstrom-Halbwellen in den ersten Zwischen-Leistungsstufen während der dritten und sechsten Halbwelle in jedem Zyklus und in den zweiten Zwischenleistungsstufen zusätzlich während der zweiten und fünften Halbwelle auf die jeweils nächstniedrigere Haupt-Leistungsstufe geschaltet wird, die im Fall der Serienschaltung die abgeschaltete Leistungsaufnahme ist. Als Schalter können Triacs verwendet werden.

Einige Ausführungsbeispiele der Erfindung werden anhand der Figuren näher erläutert. Es zeigen:
Fig. 1 eine zur Durchführung des Verfahrens geeignete Anordnung mit einer Last, die zwei Unterlasten aufweist,
Fig. 2a bis j Schaltzyklen für eine Leistungssteuerung nach dem Verfahren,
Fig. 3k und l zwei Schaltzyklen für gleichzeitigen Betrieb zweier Lasten.

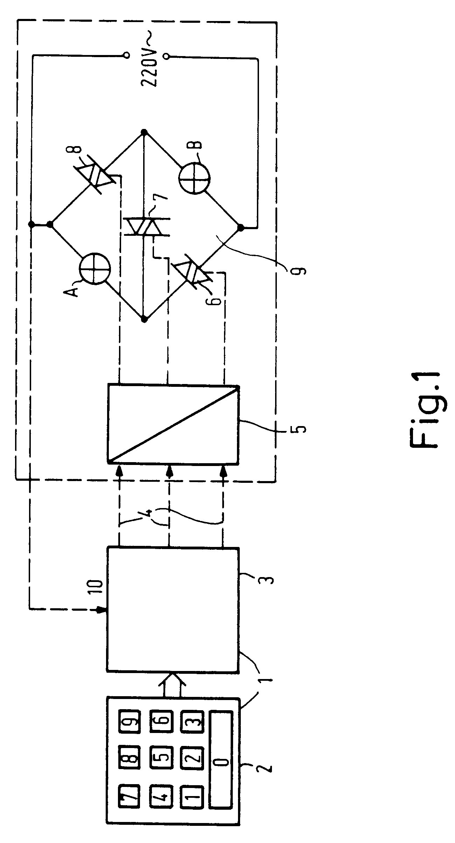

Eine in Fig. 1 dargestellte, zur Durchführung des Verfahrens zur schaltstoßarmen Leistungssteuerung elektrischer Lasten geeignete Anordnung weist eine Steuereinheit 1 auf, welche sich in eine Eingabetastatur 2 und eine elektronische Steuereinheit 3 aufteilt. Die elektronische Steuereinheit 3 wird im allgemeinen eine Mikroprozessoranordnung enthalten. Von der Steuereinheit 3 führen drei Steuerleitungen 4 zu einer Schalteinheit 5, welche in der Figur nicht näher dargestellte Optokoppler aufweist, welche über die Leitungen 4 Steuersignale von der Steuereinheit 3 empfangen. Ebenfalls in der Steuereinheit 5 sind in der Figur nicht dargestellte Triacsteuer-Elemente vorgesehen. Eine solche Schaltung aus einem Optokoppler und einem Triacsteuer-Element ist in der Zeitschrift "Siemens Components", Bd. 18 (1980, H. 2., S. 69, Bild 12, beschrieben. Diese Triacsteuer-Elemente steuern drei Triacs 6, 7 und 8, welche in einer Brückenschaltung 9 vorgesehen sind. Der Triac 6 ist in einem Brückenzweig in Reihe mit einer Last A geschaltet. Der Triac 8 ist in einem zweiten Brückenzweig in Reihe mit einer Last B geschaltet. Die Mittelpunkte der beiden Zweige sind über einen Triac 7 miteinander verbunden, der die Serienschaltung der Lasten A und B ermöglicht. Der Verbindungspunkt zwischen der Last A und dem Triac 8 einerseits sowie der Verbindungspunkt zwischen dem Triac 6 und der Last B andererseits sind mit einer Wechselspannung von 220 V verbunden.

Die beiden Lasten A und B stellen Unterlasten einer gemeinsamen elektrischen Last dar. Die Unterlasten sind hierbei Halogenlampen, die in einem Licht-Kochgerät angeordnet sind. Die Triacs 6, 7 und 8 sowie die dazu gehörige Steuerung bestehend aus der Steuereinheit 1 sowie dem Steuerelement 5 dienen dazu, die Triacs 6, 7 und 8 anzusteuern. Bei geeigneter Ansteuerung dieser Triacs können die drei Haupt-Leistungsstufen, die bei der vorliegenden Last, die sich in zwei Unterlasten aufteilt, möglich sind, geschaltet werden. Sind alle Triacs auf Sperrzustand geschaltet, sind die Lasten ausgeschaltet. Ist nur der Triac 6 auf Durchgang geschaltet, ist die Last A einzeln an die Netzspannung (220 V) geschaltet. Ist ausschließlich Triac 8 auf Durchgang geschaltet, so ist die Unterlast B an das Netz geschaltet. Ist der Triac 7 leitend geschaltet, sind die Lasten A und B in Reihe an das Netz geschaltet. Sind sowohl der Triac 6 wie auch der Triac 8 auf Durchgang geschaltet, so sind die Lasten A und B parallel an das Netz geschaltet. Durch geeignete Ansteuerung der drei Triacs 6, 7 und 8 sind also die Unterlasten A und B in geeigneter Weise auf die drei Haupt-Leistungsstufen schaltbar.

Mittels der in Fig. 1 schematisch dargestellten Anordnung können jedoch zusätzlich auch die nach dem Verfahren vorgesehenen Zwischen-Leistungsstufen geschaltet werden. Dazu wird der Steuereinheit 3 einem an ihr vorgesehenen Eingang 10 die 220 V-Netzspannung zugeführt, so daß die Steuereinheit 3 die Wechselstrom-Halbwellen des Netzes identifizieren kann.

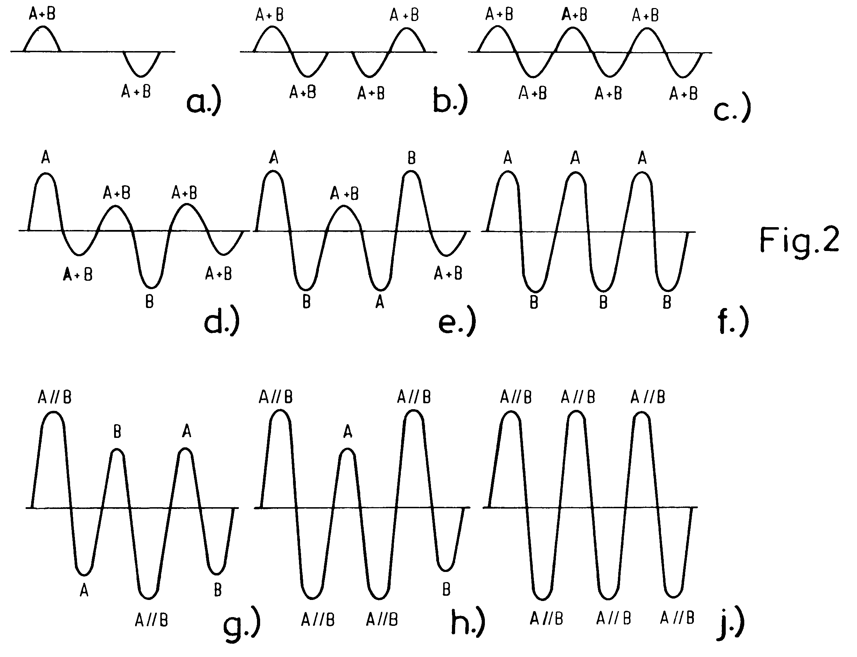

In der Fig. 2 sind nun insgesamt sechs Schaltzyklen a bis j dargestellt, in denen beispielsweise die in der Fig 1 dargestellten Lasten A und B geschaltet werden können.

Jeder dieser Zyklen weist eine Länge von jeweils sechs Halbwellen auf. Im Falle des Zyklus c sind die Lasten A und B in Reihe an das Netz geschaltet, und zwar für sämtliche sechs Halbwellen jedes Zyklus. Dieses ist die erste Haupt-Leistungsstufe. In dem Schaltzyklus f sind die Lasten A und B wechselweise einzeln an das Netz geschaltet, wobei die Last A jeweils in den Halbwellen 1, 3 und 5 und die Last B jeweils in den Halbwellen 2, 4 und 6 eines jeden Zyklus an das Netz geschaltet sind. In dem Schaltzyklus j sind die Lasten A und B jeweils parallel für sämtliche sechs Halbwellen an das Netz geschaltet. Die unterschiedlichen Amplituden der Halbwellen in den Schaltzyklen c, f und j sollen die in dieser Reihenfolge steigende Leistungsaufnahme der drei Haupt-Leistungsstufen symbolisieren.

In dem Schaltzyklus b ist die erste Zwischen-Leistungsstufe dargestellt, welche ausgehend von der Haupt-Leistungsstufe der Reihenschaltung der Lasten A und B, welche in dem Zyklus c dargestellt ist, möglich ist. In dem Schaltzyklus b der ersten Zwischen-Leistungsstufe wird während der dritten und sechsten Halbwelle des Zyklus auf abgeschaltete Leistungsaufnahme geschaltet. Da im Falle der Haupt-Leistungsstufe der Reihenschaltung beider Lasten dies quasi die nächstniedrigere Haupt-Leistungsstufe ist, die in diesem Falle Null ist. In dem Schaltzyklus a ist dann ebenfalls ausgehend von dem in c dargestellten Schaltzyklus der Haupt-Leistungsstufe der Reihenschaltung beider Lasten die zweite Zwischen-Leistungsstufe dargestellt, bei der außer jeder dritten und sechsten Halbwelle zusätzlich während jeder zweiten und fünften Halbwelle des Zyklus die Lasten auf abgeschaltete Leistungsaufnahme geschaltet wird. Bei dem in a dargestellten Schaltzyklus der zweiten Zwischen-Leistungsstufe sind die Last A und B also nur noch während der Halbwellen 1 und 4 in Reihenschaltung an das Netz geschaltet.

Ausgehend von der ersten Haupt-Leistungsstufe, deren Schaltzyklus in Fig. 2c dargestellt ist, weist die erste Zwischen-Leistungsstufe, deren Schaltzyklus in b dargestellt ist, nur noch zwei Drittel der Leistungsaufnahme auf und die in a dargestellte zweite Leistungsstufe nur noch ein Drittel der Leistungsaufnahme auf.

Ferner sind für die beiden weiteren Haupt-Leistungsstufen jeweils zwei Zwischenleistungsstufen vorgesehen. Für die in der Figur 2 im Schaltzyklus f dargestellte Haupt-Leistungsstufe, in der beide Lasten wechselweise einzeln an das Netz geschaltet werden, sind dies die erste Zwischen-Leistungsstufe, deren Schaltzyklus e ist, und die zweite Zwischen-Leistungsstufe, deren Schaltzyklus d ist.

Die von der Haupt-Leistungsstufe der wechselweisen Anschaltung der Lasten ausgehende erste Zwischen-Leistungsstufe mit ihrem Schaltzyklus e, schaltet während der dritten und sechsten Halbwelle eine Haupt-Leistungsstufe niedriger, d.h. also in diesem Falle auf die Haupt-Leistungsstufe der Reihenschaltung der Lasten A und B. Somit sind in der zweiten Zwischen-Leistungsstufe in deren Schaltzyklus e während der Halbwellen 1 und 4 die Last A einzeln, während der Halbwellen 2 und 5 die Last B einzeln und während der Halbwellen 3 und 6 die Lasten A und B in Reihe an das Netz geschaltet. In der zu dieser Haupt-Leistungsstufe gehörenden zweiten Zwischen-Leistungsstufe, deren Schaltzyklus in Fig. 2d dargestellt ist, wird zusätzlich während der Halbwellen 2 und 5 auf Reihenschaltung der beiden Lasten geschaltet, so daß während der ersten Halbwelle dieses Zyklus die Last A einzeln, während der vierten Halbwelle dieses Zyklus die Last B einzeln und während der übrigen Halbwellen des Zyklus die beiden Lasten in Reihe an das Netz geschaltet sind.

In Fig. 2j ist die dritte Haupt-Leistungsstufe dargestellt, in der die Lasten A und B an das Netz geschaltet sind. Auch ausgehend von dieser Haupt-Leistungsstufe gibt es wiederum zwei Zwischen-Leistungsstufen, die in den Fig. 2h und 2g dargestellt sind. In 2h ist die erste Zwischen-Leistungsstufe dargestellt, in der während der dritten und sechsten Halbwelle des Zyklus eine Haupt-Leistungsstufe niedriger geschaltet wird, so daß in diesem Falle während dieser Zyklen wechselweise die Lasten A und B eingeschaltet werden, was im vorliegenden Beispiel bedeutet, daß während der Halbwelle 3 die Last A einzeln und während der Halbwelle 6 die Last B einzeln eingeschaltet sind. Während der übrigen Halbwellen dieses Zyklus sind die Lasten A und B weiterhin parallel an das Netz geschaltet. In dem Schaltzyklus g ist die zweite Zwischen-Leistungsstufe, die sich ausgehend von der Haupt-Leistungsstufe der Parallelschaltung der Lasten ergibt, dargestellt. Hier werden während der Halbwellen 2 und 3 und 5 und 6 die Lasten A und B wechselweise einzeln an das Netz geschaltet, während während der Halbwellen 1 und 4 weiterhin die Lasten A und B parallel geschaltet sind. Im vorliegenden Falle ist die Last A während der Halbwellen 2 und 5 und die Last B während der Halbwellen 3 und 6 jeweils einzeln an das Netz geschaltet.

In dem in der Fig. 2 dargestellten Ausführungsbeispiel sind also jeweils die Zyklen der beiden Zwischen-Leistungsstufen dargestellt, die sich für jede der drei Haupt-Leistungsstufen nach dem Verfahren ergeben. Für die Haupt-Leistungsstufe, deren Schaltzyklus in c dargestellt ist, ergeben sich die erste Zwischen-Leistungsstufe mit ihrem Schaltzyklus b und die zweite Zwischen-Leistungsstufe mit ihrem Schaltzyklus a. Für die Haupt-Leistungsstufe mit ihrem Schaltzyklus f ergibt sich die erste Zwischen-Leistungsstufe mit ihrem Schaltzyklus e und die zweite Zwischen-Leistungsstufe mit ihrem Schaltzyklus d, sowie für die in j dargestellte Haupt-Leistungsstufe die erste Zwischen-Leistungsstufe mit ihrem Schaltzyklus h sowie die zweite Zwischen-Leistungsstufe mit ihrem Schaltzyklus g.

Bei dem in der Fig. 2 dargestellten Beispiel sind also zusätzlich zu den drei Haupt-Leistungsstufen insgesamt sechs weitere Zwischen-Leistungsstufen vorgesehen. Diese insgesamt neun Leistungsstufen weisen in der alphabetischen Reihenfolge ihrer in der Fig. 2 dargestellten Zeitzyklen steigende Leistungsaufnahme auf.

Es lassen sich auch noch weitere Leistungsstufen zwischen den neuen Leistungsstufen, die aus den drei Haupt-Leistungsstufen und den sechs Zwischen-Leistungsstufen bestehen, erzeugen, indem zwischen zwei benachbarten Leistungsstufen hin- und hergeschaltet wird. Beispielsweise kann zur Erzeugung einer weiteren Leistungsstufe die Steuereinheit 1 zuerst einen ersten Zyklus von sechs Halbwellen nach Fig. 2a (zweite Zwischenleistungsstufe, die sich ausgehend von der Haupt-Leistungsstufe der Serienschaltung der Lasten ergibt) anregen und in fünf weiteren Zyklen von sechs Halbwellen die Leistungsaufnahme abschalten. Anschließend wird wieder der Schaltzyklus nach Fig. 2a erzeugt und dann die Leistungsaufnahme für fünf Zyklen abgeschaltet.

Beim Einschalten wird die Steuereinheit 1, um die Schaltstoßbelastung möglichst gering zu halten, zunächst den Schaltzyklus mit der niedrigsten Leistungsstufe wählen. Nach der Dauer wenigstens eines Zyklus wird auf den Schaltzyklus mit der nächsthöheren Leistungsaufnahme geschaltet. Dies wird bis zum Erreichen der vorgewählten Leistungsstufe fortgesetzt.

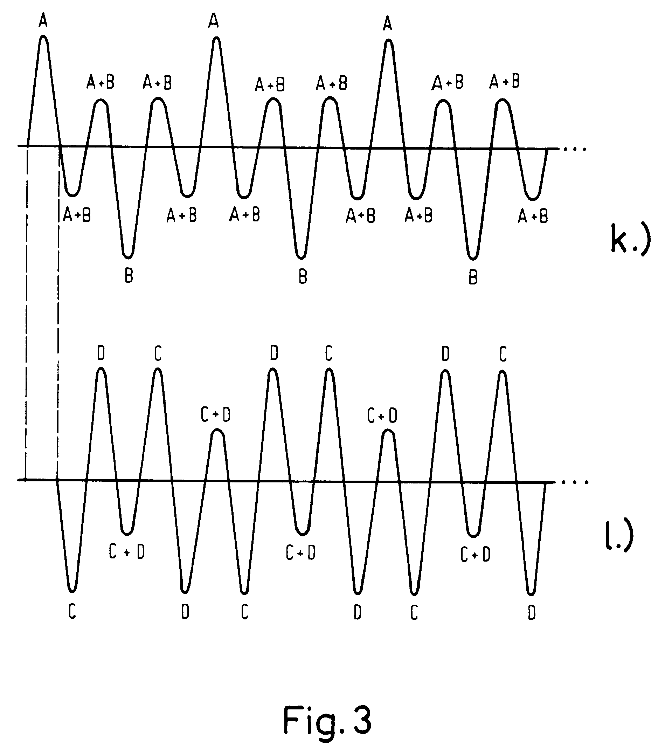

In der Fig. 3 sind untereinander die Schaltzyklen zweier in der Figur nicht dargestellter Lasten wiedergegeben. Im oberen Kurvenverlauf ist der Schaltzyklus einer Last angegeben, die zwei Unterlasten A und B aufweist. Im unteren Kurvenverlauf ist der Zyklus einer Last angegeben, welche zwei Unterlasten C und D aufweist.

Jede dieser zwei Lasten kann beispielsweise in einer in der Fig. 1 dargestellten Anordnung geschaltet werden.

Im oberen Kurvenverlauf ist der Schaltzyklus der Unterlasten A und B dargestellt. Die beiden Unterlasten sind auf die zweite Zwischen-Leistungsstufe ausgehend von der Haupt-Leistungsstufe der wechselweisen Anschaltung der beiden Lasten geschaltet.

Da somit die erste Last auf eine der möglichen zweiten Zwischen-Leistungsstufen geschaltet ist, wird nach dem Verfahren die zweite Last, welche die Unterlasten C und D aufweist, gegenüber dem Zyklus der ersten Last zeitlich um die Dauer einer Halbwelle verschoben angeschaltet. Die beiden Unterlasten C und D sind in dem vorliegenden Beispiel auf die erste Zwischen-Leistungsstufe, ausgehend von der Hauptleistungsstufe der wechselweisen Anschaltung der Lasten, an das Netz geschaltet. Aufgrund der zeitlichen Verschiebung des Zyklus der zweiten Last wird die Last C einer Halbwelle verzögert eingeschaltet, d.h. also während der zweiten Halbwelle der Lasten A und B.

Bei dieser Konstellation ergibt sich eine relativ gleichmäßige Leistungsaufnahme bei Betrieb beider Hauptlasten, da die Leistungsspitzen der beiden Lasten infolge der Verschiebung des Schaltzyklus einer der Lasten, nicht zeitlich zusammenfallen. Im vorliegenden Beispiel nehmen die Lasten C und D relativ große Leistungen auf, wenn die Lasten A und B aufgrund der Serienschaltung der beiden Lasten relativ geringe Leistung aufnehmen.

## Patentansprüche

1. Verfahren zur schaltstoßarmen Leistungssteuerung elektrischer Lasten, insbesondere Heizlasten, welche in je wenigstens zwei gleiche Unterlasten elektrisch aufgeteilt sind, bei dem die Unterlasten jeder Last wahlweise in wenigstens drei Haupt-Leistungsstufen in Serienschaltung, wechselweise einzeln oder in Parallelschaltung an ein Wechselstromnetz schaltbar sind,
dadurch gekennzeichnet, daß zur feineren Leistungssteuerung zusätzlich sechs Zwischen-Leistungsstufen vorgesehen sind, bei denen ausgehend von einer der drei Haupt-Leistungsstufen in einem sich laufend wiederholenden Zyklus von sechs Wechselstrom-Halbwellen in den ersten Zwischen-Leistungsstufen während der dritten und sechsten Halbwelle in jedem Zyklus und in den zweiten Zwischenleistungsstufen zusätzlich während der zweiten und fünften Halbwelle auf die jeweils nächstniedrigere Haupt-Leistungsstufe geschaltet wird, die im Fall der Serienschaltung die abgeschaltete Leistungsaufnahme ist.

2. Verfahren nach Anspruch 1,
dadurch gekennzeichnet, daß zum Umschalten von einer ersten auf eine zweite, höhere Leistungsstufe ausgehend von der ersten Leistungsstufe nacheinander und in aufsteigender Folge die jeweils nächsthöhere Leistungsstufe für die Dauer wenigstens eines Zyklus eingeschaltet wird bis die zweite Leistungsstufe erreicht ist.

3. Verfahren nach Anspruch 2,
dadurch gekennzeichnet, daß zum Umschalten auf eine zweite, niedrigere Leistungsstufe in entsprechender Weise mit absteigender Folge der Leistungsstufen verfahren wird.

4. Verfahren nach einem der Ansprüche 1 bis 3,
dadurch gekennzeichnet, daß beim Einschalten der Unterlasten auf eine beliebige Leistungsstufe zunächst für die Dauer wenigstens eines Zyklus auf die niedrigste Zwischen-Leistungsstufe geschaltet wird.

5. Verfahren nach einem der Ansprüche 1 bis 4,
dadurch gekennzeichnet, daß weitere Zwischenabstufungen der Leistungsaufnahme vorgesehen sind, für die zwischen zwei benachbarten Leistungsstufen für die Dauer von ganzen Vielfachen eines Zyklus hin- und hergeschaltet wird.

6. Verfahren nach einem der Ansprüche 1 bis 5,
dadurch gekennzeichnet, daß weitere Leistungsstufen unterhalb der kleinsten Zwischen-Leistungsstufe vorgesehen sind, für die zwischen dieser und der abgeschalteten Leistungsaufnahme für die Dauer ganzer Vielfacher eines Zyklus hin- und hergeschaltet wird.

7. Verfahren nach einem der Ansprüche 1 bis 6,
dadurch gekennzeichnet, daß bei Betrieb zweier oder mehr Lasten, deren Unterlasten auf Zwischen-Leistungsstufen geschaltet sind, der Zyklus der zweiten Last gegenüber dem Zyklus der ersten Last zeitlich um die Dauer von zwei Halbwellen verschoben wird, wenn die erste Last auf eine der ersten Zwischen-Leistungsstufen geschaltet ist, und daß ihr Zyklus um die Dauer einer Halbwelle verschoben wird, wenn sie auf eine der zweiten Zwischen-Leistungsstufen geschaltet ist.

8. Verfahren nach einem der Ansprüche 1 bis 7,
dadurch gekennzeichnet, daß die Unterlasten einer Last gleiche Leistungsaufnahme aufweisen.

9. Licht-Kochgerät mit wenigstens einer Heizlast, die zwei als Unterlasten vorgesehene Halogenlampen enthält, welche mit Schaltern eine Brückenschaltung bilden, und mit einer Steuereinheit, welche die Schalter so steuert, daß die Unterlasten über mindestens sechs Wechselstrom-Halbwellen wahlweise in drei Haupt-Leistungsstufen in Serienschaltung, welchselweise einzeln oder in Parallelschaltung an ein Wechselstromnetz schaltbar sind, zur Durchführung des Verfahrens nach einem der Ansprüche 1 bis 8,
dadurch gekennzeichnet, daß die Steuereinheit die Schalter so steuert, daß zusätzlich die Unterlasten wahlweise in sechs Zwischenleistungsstufen schaltbar sind, wobei ausgehend von einer der drei Haupt-Leistungsstufen in einem sich laufend wiederholenden Zyklus von sechs Wechselstrom-Halbwellen in den ersten Zwischen-Leistungsstufen während der dritten und sechsten Halbwelle in jedem Zyklus und in den zweiten Zwischenleistungsstufen zusätzlich während der zweiten und fünften Halbwelle auf die jeweils nächstniedrigere Haupt-Leistungsstufe geschaltet wird, die im Fall der Serienschaltung die abgeschaltete Leistungsaufnahme ist.

## Claims

1. A method for power control of electric loads without switching transients, particularly of heating loads which are electrically subdivided into at least two equal subloads, while the subloads of each load can be connected to a AC mains with at least three main power levels, as desired, in a series arrangement, alternately singly, or in a parallel arrangement, characterized in that in addition six intermediate power levels are provided for finer power control in which, staring from one of the three main power levels and in a cycle of six AC half-waves which continuously repeats itself, the control switches to the relevant next lower main power level, which in the case of the series arrangement is the zero power level, during the third and sixth half-wave of each cycle to obtain the first intermediate power levels and in addition during the second and fifth half-wave to obtain the second intermediate power level.

2. A method as claimed in Claim 1, characterized in that when a switch is made from a first to a second, higher power level, all the relevant next higher power levels starting from the first power level are switched on consecutively and in rising order each for the duration of at least one cycle until the second power level has been reached.

3. A method as claimed in Claim 2, characterized in that a switch-over to a second, lower power level is made in a similar manner with a falling order of power levels.

4. A method as claimed in any one of the Claims 1 to 3, characterized in that when the subloads are switched on to any power level, a switch is made to the lowest intermediate power level first for the duration of at least one cycle.

5. A method as claimed in any one of the Claims 1 to 4, characterized in that further intermediate gradations of the power consumptions are provided, for which switching operations are carried out between two adjoining power levels for the duration of multiples of a full cycle.

6. A method as claimed in any one of the Claims 1 to 5, characterized in that further power levels below the lowest intermediate power level are provided, for which switching operations take place between this lowest power level and the zero power consumption for the duration of multiples of a full cycle.

7. A method as claimed in any one of the Claims 1 to 6, characterized in that in the operation of two or more loads whose subloads are switched to intermediate power levels, the cycle of the second load is shifted in time in relation to the cycle of the first load by a period of two half-waves when the first load is switched to one of the first intermediate power stages, and that its cycle is shifted for the period of one half-wave when it is switched to one of the second intermediate power levels.

8. A method as claimed in any one of the Claims 1 to 7, characterized in that the subloads of one load have the same power consumptions.

9. A radiation cooker with at least one heating load which comprises two halogen lamps provided as subloads which form a bridge circuit together with switches, and comprising a control unit which controls the switch so that the subloads can be connected to a AC mains with three main power levels in series arrangement, alternately singly, or in parallel arrangement, as desired, over at least six AC half-waves. This arrangement, for carrying out the method as claimed in any one of the Claims 1 to 8, characterized in that the control unit controls the switch in such a manner that the subloads can in addition be switched to six intermediate power levels as desired, whereby, staring from one of the three main power levels and in a cycle of six AC half-waves which continuously repeats itself, the control switches to the relevant next lower main power level, which in the case of the series arrangement is the zero power level, during the third and sixth half-wave of each cycle to obtain the first intermediate power levels and in addition during the second and fifth half-wave to obtain the second intermediate power level.

## Revendications

1. Procédé de commutation de puissance de charges électriques pauvres en impulsions dues à la commutation, notamment de charges de chauffage, divisées électriquement chaque fois en au moins deux sous-charges égales, suivant lequel les sous-charges de chaque charge peuvent être branchées en au moins trois étages de commutation principaux facultativement en série, alternativement individuellement ou en parallèle sur un réseau de courant alternatif, caractérisé en ce qu'on a prévu encore six étages de puissance intermédiaires dans lesquels en partant de l'un des trois étages de puissance principaux, dans un cycle de répétition continu constitué de six demi-ondes de courant alternatif, il est commuté chaque fois dans les premiers étages de puissance intermédiaires pendant la troisième et la sixième demi-onde de chaque cycle et dans les deuxièmes étages de puissance intermédiaires pendant la deuxième et la cinquième demi-onde, à l'étage de puissance principal suivant inférieur qui, dans le cas d'un montage en série est constitué par la puissance absorbée déconnectée.

2. Procédé selon la revendication 1, caractérisé en ce que pour la commutation d'un premier à un deuxième étage de puissance supérieur en partant du premier étage de puissance et un ordre montant l'étage de puissance suivant supérieur est ensuite connecté pour la durée d'au moins un cycle jusqu'à ce que le deuxième étage de puissance soit atteint.

3. Procédé selon la revendication 2, caractérisé en ce que pour la commutation à un deuxième étage de puissance inférieur on procède de la même manière en ordre descendant des étages de puissance.

4. Procédé selon l'une des revendications 1 à 3, caractérisé en ce que lors de la connexion des sous-charges à un étage de puissance quelconque, il est commuté d'abord à l'étage de puissance intermédiaire inférieur pendant la durée d'au moins un cycle.

5. Procédé selon l'une des revendications 1 à 4, caractérisé en ce qu'il est prévu des échelonnements intermédiaires plus fins de la puissance absorbée, cas dans lequel il est commuté entre deux étages de puissance voisins pendant la durée de multiples entiers d'un cycle.

6. Procédé selon l'une des revendications 1 à 5, caractérisé en ce qu'il est prévu d'autres étages de puissance en deçà de l'étage de puissance intermédiaire le plus faible, cas dans lequel il est commuté entre lesdits étages de puissance et la puissance absorbée déconnectée pendant la durée de multiples entiers d'un cycle.

7. Procédé selon l'une des revendications 1 à 6, caractérisé en ce que pendant le fonctionnement de deux ou de plusieurs charges dont les sous-charges sont commutées à des étages de puissance intermédiaires, le cycle de la deuxième charge par rapport au cycle de la première charge est décalé dans le temps pour la durée de deux demi-ondes, lorsque la première charge est commutée à l'un des premiers étages de puissance intermédiaires, et que son cycle est décalé pour la durée de deux demi-ondes, lorsqu'elle est commutée à l'un des deuxièmes étages de puissance intermédiaires.

8. Procédé selon l'une des revendications 1 à 7, caractérisé en ce que les sous-charges d'une charge présentent la même puissance absorbée.

9. Appareil de cuisson utilisant de la lumière comme source de chauffage et présentant au moins une charge de chauffage comportant deux lampes aux halogènes prévues comme sous-charges, qui constituent avec des commutateurs un circuit en pont, et une unité de commande commandant les commutateurs de manière que les sous-charges peuvent être branchées, pendant au moins six demi-ondes de courant alternatif, dans trois étages de puissance principaux, facultativement en série, alternativement individuellement ou en parallèle sur un réseau de courant alternatif pour la mise en oeuvre du procédé suivant l'une des revendications 1 à 8, caractérisé en ce que l'unité de commande commande les commutateurs de manière que non seulement les sous-charges peuvent être commutées facultativement en six étages de puissance intermédiaires, cas dans lequel en partant de l'un des trois étages de puissance principaux il est commuté, dans un cycle se répétant continuellement et comportant six demi-ondes de courant alternatif, dans les premiers étages de puissance intermédiaires pendant la troisième et la sixième demi-onde de chaque cycle mais encore dans les deuxièmes étages de puissance intermédiaires pendant la deuxième et la cinquième demi-onde, chaque fois à l'étage de puissance principal suivant inférieur constituant la puissance absorbée déconnectée dans le cas d'un montage en série.
